# EUROPEAN PATENT SPECIFICATION

(11) **EP 4 210 164 B1**
(45) Date of publication and mention of the grant of the patent: **28.01.2026**
(21) Application number: 23159350.0
(22) Date of filing: 01.06.2021
(51) Int. Cl.: H01P 3/12, H01P 3/08, H01P 1/20, H01Q 21/06

(54) **MULTI-LAYER WAVEGUIDE WITH METASURFACE, ARRANGEMENT, AND METHOD FOR PRODUCTION THEREOF**
MEHRSCHICHTIGER WELLENLEITER MIT METAOBERFLÄCHE, ANORDNUNG UND VERFAHREN ZU DESSEN HERSTELLUNG
GUIDE D'ONDES MULTICOUCHE À MÉTASURFACE, AGENCEMENT ET SON PROCÉDÉ DE PRODUCTION

(30) Priority: 09.06.2020 SE 2050679
(43) Date of publication of application: 12.07.2023
(62) Divisional of application: 21731604.1
(73) Proprietor: Gapwaves AB, 412 63 Göteborg (SE)
(72) Inventor: VOSOOGH, Abbas, 417 61 Göteborg (SE)
(74) Representative: Lind Edlund Kenamets Intellectual Property AB

(56) References cited:
- WO-A1-2019/083439
- RU-C1- 2 696 676
- VOSOOGH ABBAS ET AL: "Novel Air-Filled Waveguide Transmission Line Based on Multilayer Thin Metal Plates", IEEE TRANSACTIONS ON TERAHERTZ SCIENCE AND TECHNOLOGY, IEEE, PISCATAWAY, NJ, USA, vol. 9, no. 3, 1 May 2019 (2019-05-01), pages 282 - 290, XP011723298, ISSN: 2156-342X, [retrieved on 20190507], DOI: 10.1109/TTHZ.2019.2905775
- HESLER J ED - SIGMON B (ED): "A PHOTONIC CRYSTAL JOINT (PCJ) FOR METAL WAVEGUIDES", 2001 IEEE MTT-S INTERNATIONAL MICROWAVE SYMPOSIUM DIGEST.(IMS 2001). PHOENIX, AZ, MAY 20 - 25, 2001; [IEEE MTT-S INTERNATIONAL MICROWAVE SYMPOSIUM], NEW YORK, NY : IEEE, US, 20 May 2001 (2001-05-20), pages 783 - 786, XP001067384, ISBN: 978-0-7803-6538-4, DOI: 10.1109/MWSYM.2001.967009

## Description

### Technical field

The present invention relates generally to a multi-layer waveguide transmission line with layers comprising electromagnetic metasurfaces.

### Background art

Waveguides are well known in the art and a common component used to carry electromagnetic waves from a starting point to an endpoint. In its most general term, a waveguide could be a hollow metal pipe.

For waves propagating in open space power is lost over distance reducing both the possible transmission distance and the quality of a wave. Waveguides are therefore a structure adapted to guide waves by restricting the expansion directions of the wave in at least one dimension. The concept is to restrict the wave forcing it to propagate in a specific direction and thereby reducing the losses. In ideal conditions, this would result in the wave losing no power at all, however, this is rarely or never the case. Depending on the waveguide transmission line there is loss and leakage and the waves couple to the edges of the waveguide channels creating energy losses. The concept of waveguides has been known for a long time and is used for transmitting for example signals, sound, or light.

Simultaneously, the use of wireless communication increase and there is a demand from the market for waveguides and antenna arrays based on such technology. The demand from the market further requires compact and inexpensive waveguides.

One available solution is substrate integrated waveguides (SIW) that are compact waveguides based on printed circuit board (PCB) technology and connected top and bottom layers using via holes. Via holes are holes extending between the layers of a waveguide, connecting at least the top and bottom layers. Although cost efficient production methods exist for substrate integrated waveguide the cost increase with increasing frequency due to need for high frequency dielectric.

Another available solution is so called gap waveguide technology. Gap waveguides are generally constructed from two parts where one has pins forming a barrier that prevent propagation of electromagnetic waves in directions other than the intended waveguide direction, thus reducing leakage in such structures. Gap waveguides are suitable for some applications but have limitations in size, typical height of pins is the wavelength divided by 2 to 6, i.e. lambda/2 to lambda/6. In WO2019083439 a multi-layer waveguide device with multiple layers having through going holes extending through the entire respective layer is presented. In "Novel Air-Filled Waveguide Transmission Line Based on Multilayer Thin Metal Plates", Vosoogh, Abbas et al, 1 May 2019 a method of constructing waveguiding structures by stacking several thin metal plates for millimeter-wave and terahertz applications is presented. In RU2696676 ridge waveguides without side walls are presented. In "A Photonic Crystal Joint (PCJ) for Metal Waveguides", Hesler J Ed - Sigmon B (Ed), 20 May, 2001 a method to eliminate currents in joints or interfaces in enclosed metal microwave structures is presented.

### Summary of invention

Although technologies for compact waveguides are available there is a need for compact components, low loss components with good reduction of loss and leakage. SIW, as one example, have an inherent insertion loss that is higher than the corresponding loss of for example air-filled hollow waveguide. Thus, although they provide a cost-efficient alternative there are a need for other solutions. Hollow waveguides generally have other drawbacks, for example the magnetic fields penetrate a short distance into the metal creating leaks that become substantial if there is a gap between two layers, especially if the gap is in the horizontal direction, when making hollow waveguide structure in split-blocks. The reason for this is that the electromagnetic waves are tightly confined and meant to penetrate only a very short distance into the metal.

Dielectric waveguides are another option to reduce leakage however the characteristics of the problem is different for such waveguides due to for example the non-propagating evanescent wave. This is also the reason why such waveguides require high level of conductivity between layers in order to reduce leakage. The high level of conductivity significantly increases the production cost and requires very high accuracy during manufacturing. In addition, the losses are in general still higher than for air-filled waveguide.

Gap waveguides have limitations both in design and size of pin texture making them a useful solution but not applicable for some applications.

A further problem exists in relation to manufacturing of waveguides is that the current level of CNC-milling and molding often provides bad tolerances in the production method compared to other methods such as laser cutting, etching, or chemical etching. This makes it difficult and/or expensive to produce waveguide structures. The problem is more evident for some frequency ranges than for others, for example both CNC-milling and molding are common production methods for waveguides adapted for frequencies below 60 GHz. In higher E-band and D-band frequency range, 71 GHz to 86 GHz and 110 GHz to 170 GHz, the CNC-milling and molding becomes very expensive because everything is very small in relation to how the production technology works. Thereby, it is in some cases not suitable and in some cases not even possible to achieve the desired result.

An object is to provide a new realization of air-filled waveguide transmission line that is easy to produce.

Another object is to provide a waveguide that is cost effective to produce.

Another object is to provide a waveguide that conveniently can be used and design for antenna arrays.

Another object is to provide a waveguide that conveniently can be used to design waveguide filters and diplexers.

Another object is to provide a waveguide that conveniently can be used for active electronic circuits, i.e. power amplifiers (PA), packaging and integration with passive components such as array antennas.

Another object is to provide a multi-layer waveguide with stacked unconnected layers with low leakage.

Another object is to provide a multi-layer waveguide that don't require galvanic contact between the layers to reduce leakage.

Another object of the present invention is to provide a multi-layer waveguide that don't require connectivity between the layers to reduce leakage.

Yet another object of the present invention is to provide a multi-layer waveguide that is compact in comparison to prior art solutions.

It would thus be beneficial with a waveguide that is compact and overcomes at least some of the drawbacks of the prior art.

Thus, the present solution, defined by the appended claims, relates to a cost efficient and easy to produce multi-layer waveguide transmission line with electromagnetic metasurfaces arranged in a specific configuration. The solution is a compact air-filled waveguide with unconnected thin layers stacked together and overcoming many of the drawbacks of prior art solutions. The solution can advantageously be used with metal layers with typical thickness of lambda/10 or lambda/15 and depth of the leak suppressing structure below lambda/20 or even lambda/30. The multi-layer waveguide comprises at least three physical layers assembled into a multi-layer waveguide. The layers are at least one top layer, one or more intermediate layer, and one bottom layer. The multi-layer waveguide further comprises a waveguide channel being an elongated aperture in at least one intermediate layer. At least one layer has a metasurface on a first surface facing a first adjoining layer and the metasurface surrounds the elongated aperture. The metasurface comprise thick and thin sections.

The waveguide channel is in different embodiments arranged with different sizes of elongated apertures in the layers, in some embodiments all layers have different sizes of elongated apertures and in other embodiments some of the layers have corresponding apertures.

The metasurface is a textured surface that have a sub-wavelength thickness, in this particular case, normally below lambda/10. The textured surface comprises thin and thick sections that creates the texture.

It is one advantage that the meta structure in the multi-layer arrangement create a leak reduction effect by the small gap between the layers and the metasurfaces. The effect comes from an electromagnetic band gap but in comparison to previous multi-layer waveguides the metasurface structure has the advantage of being smaller in size and still inexpensive to produce.

According to one embodiment the first surface has a flat portion surrounding the metasurface. The thick sections have a thickness corresponding to the layer thickness at the flat portion and the thin sections have a thickness that is less than the thickness at the flat portion.

According to one embodiment, a second surface of the intermediate layer is facing a second adjoining layer that has a flat surface except for the elongated aperture.

The metasurface faces a flat surface creating small air-filled spaces between the surfaces of the layers creating an electromagnetic band gap structure.

According to one embodiment, the layers are stacked separate layers without elements extending between the layers.

It is one advantage with the present solution that a small gap is acceptable between all or some of the layers without increasing leakage.

According to one embodiment, each thick section has any one of a circular, elliptical, triangular, square, pentagonal, rectangular, rectangular, square, hexagonal, or rectangular shape.

It is one advantage that the shape of the thick sections could vary between different layers or different waveguides.

According to one embodiment the thick sections are arranged in rows parallel to the elongated aperture.

According to one embodiment the thick sections are arranged at irregular distances from the elongated aperture.

According to one embodiment the thick sections are arranged in a random pattern surrounding the elongated aperture.

According to one embodiment the metasurface surrounds the elongated aperture.

According to one embodiment, the multi-layer waveguide comprises a first, second, and third intermediate layer each comprises an elongated aperture, and the second intermediate layer further comprises a central member arranged within the elongated aperture.

In different embodiments all or some layers have metasurfaces. In one embodiment only intermediate layers have metasurfaces, in another embodiment at least one of the top and bottom layers have a metasurface. The metasurfaces are in one embodiment arranged to face a flat surface of an adjoining layer, i.e. two metasurfaces don't face each other in such an embodiment.

According to one embodiment, the multi-layer waveguide comprises a first, second, and third intermediate layer wherein the second intermediate layer is a non-textured layer for integrated electronic chipsets.

**It** is one advantage that a non-textured layer, i.e. a layer without a metasurface could be used for integrating electronic chipsets.

According to one embodiment, the difference in thickness between the thick sections and the thin sections of the metasurface is less than the wavelength divided by 10.

According to one embodiment, the difference in thickness between the thick sections and the thin sections of the metasurface is less than the wavelength divided by 20.

According to one embodiment, the difference in thickness between the thick sections and the thin sections of the metasurface is less than the wavelength divided by 30.

**It** is one advantage with the present solution that the metasurface enables waveguides that are smaller in size comparing to other available alternatives without increasing the leakage. **It** is another advantage that the multi-layer structure in combination with the metasurfaces that leakage between the layers is significantly reduced. Although larger metasurface is a possibility it is one clear advantage that smaller metasurfaces are easier to produced than alternatives for corresponding frequencies.

According to one aspect, a method for producing a multi-layer waveguide as described herein is disclosed.

According to an embodiment the metasurface of different layers in the multi-layer waveguide has an asymmetric configuration.

It is one advantage of the present solution that the metasurfaces of each layer in the multi-layer waveguide that has a metasurface don't have to be identical. The metasurfaces could for example be arranged with thick and thin sections aligning with each other between layers or arranged in an asymmetric configuration wherein the thin and thick sections don't align.

According to an embodiment the thin and thick sections are arranged periodically along a perimeter outside the elongated aperture of each layer.

According to one embodiment the metasurface is not identical on each layer.

According to an embodiment the central member of an elongated aperture is connected to the rest of the layer with one connection tab spanning the aperture, wherein the connection tab is an integrated part of the layer.

According to an embodiment the distance between the layers of the multi-layer waveguide is between 0 and 20 microns.

According to an embodiment the distance between the layers of the multi-layer waveguide is between 0 and 50 microns.

According to an embodiment the multi-layer waveguide is a transmission line implemented as any one of an antenna, an antenna array, and a filter.

It is one advantage with the present solution that the multi-layer waveguide can be implemented as for example a slotted waveguide antenna.

It is another advantage with the present solution that the multi-layer waveguide can be implemented for chipset packaging, such as packaging of MMIC (Monolithic Microwave Integrated Circuit).

According to an embodiment the waveguide is made from one single material.

According to an embodiment the multi-layer waveguide is made from layers of a single material coated with a metal.

According to an embodiment the multi-layer waveguide is assembled with a non-conductive adhesive.

According to an embodiment the layers are directly stacked.

According to an embodiment the layers are stacked unconnected thin layers.

It is one advantage that the multi-layer waveguide doesn't require any galvanic, electric, or physical connection between the layers. I.e. a small gap can exist between the layers. This gap could for example be an uncontrolled air gap from production of the layers. The gap could also be on micron or even an atomic level.

According to an embodiment the layers are stacked unconnected thin metal layers.

According to an embodiment the layers of the multi-layer waveguide is held together with any one of a conductive glue, an isolating glue, and two screws.

It is one advantage with the present solution that any form of bonding or attachment means can be used to hold the layers together. The reason for this is that no electric conductivity is required between the layers in order to suppress leakage. However, it shall be noted that conductivity won't affect the performance in a negative way. I.e. the multi-layer waveguide according to the solution as described herein works well regardless of the conductive properties between the layers.

### Brief description of drawings

The invention is now described, by way of example, with reference to the accompanying drawings, in which:
Fig. 1 illustrates one embodiment of a multi-layer waveguide with layers comprising a metasurface, wherein the top layer is presented as an exploded view.
Fig. 2 illustrates one embodiment of an isometric cross-section of an intermediate layer.
Fig. 3 illustrates an exploded view of one embodiment of a multi-layer waveguide with layers comprising a metasurface.
Fig. 4 illustrates a cross-section of an embodiment as illustrated in figure 3.
Fig. 5 illustrates a cross-section of part of an intermediate layer where thin and thick sections of a metasurface is illustrated in detail.
Fig. 6 illustrates a cross-section showing one embodiment of metasurfaces in multiple layers wherein the metasurface is produced using chemical etching as the fabrication method.
Fig. 7 illustrates one embodiment showing a co-axial multi-layer waveguide with metasurfaces in multiple layers.
Fig. 8 illustrates a cross-section of one embodiment of a co-axial multi-layer waveguide with a flat layer between multiple layers with metasurfaces.
Fig. 9 illustrates a cross-section of one embodiment of a rectangular multi-layer waveguide with metasurfaces in a bottom layer.
Fig. 10 illustrates one embodiment wherein the metasurface section have a round shape.
Fig. 11 illustrates one embodiment wherein the thick and/or thin sections are unevenly arranged in the metasurface.
Fig. 12 illustrates one embodiment wherein multiple waveguides are arranged as slotted waveguide antennas in one unit.
Fig. 13 illustrates a bottom view of a top layer according to the embodiment as illustrated in Fig. 12.
Fig. 14 illustrates one embodiment of a multi-layer waveguide arranged as a slotted waveguide antenna.
Fig. 15 illustrates one embodiment of a multi-layer waveguide arranged as a slotted waveguide antenna, wherein corrugations to reduce unwanted signal propagations are arranged in the extension direction of the waveguide channel.

### Description of embodiments

In the following, a detailed description of the different embodiments of the invention is disclosed under reference to the accompanying drawings. All examples herein should be seen as part of the general description and are therefore possible to combine in any way of general terms. Individual features of the various embodiments and aspects may be combined or exchanged unless such combination or exchange is clearly contradictory to the overall function of the multi-layer waveguide, arrangement, or production method thereof.

Briefly described the solution relates to a compact multi-layer waveguide without any requirement for electrical and galvanic contact between the layers. The multi-layer waveguide has metasurfaces in layers arranged as leak suppressing structure for reducing energy leakage between the layers of the waveguide. The metasurface comprise multiple thick and thin sections surrounding a waveguide channel.

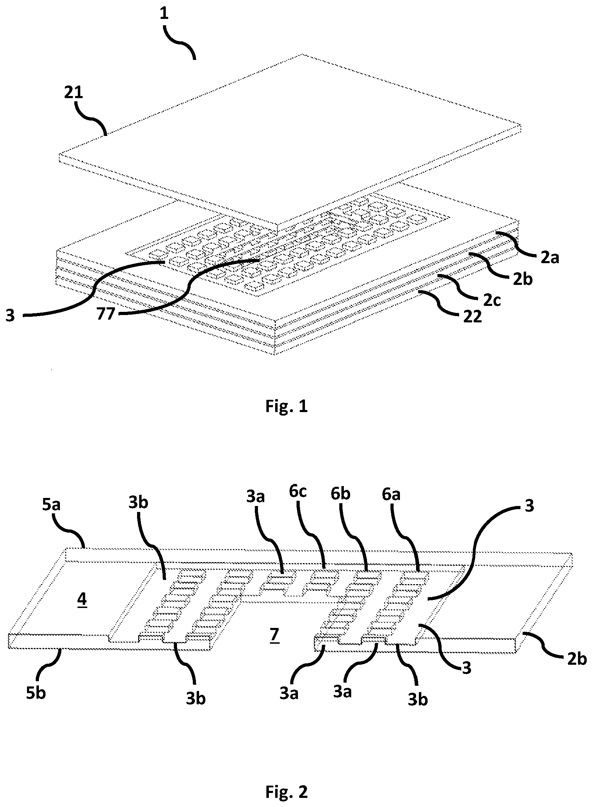

Figure 1 illustrates one embodiment of a multi-layer waveguide 1 with multiple layers 21, 2a, 2b, 2c, 22 of a multi-layer waveguide. The intermediate layers 2a, 2b, 2c, 2d, 2e each has an elongated aperture 7 that alone or together with elongated apertures of other layers creates a waveguide channel 77. The elongated aperture 7 is in some or all of the intermediate layers surrounded by a metasurface.

Figure 2 illustrates a cross-section of part of an intermediate layer 2b. The layer comprises an elongated aperture 7 which off only part is visible in the illustration of figure 2. The elongated aperture 7 is surrounded by a metasurface 3 comprising thick 3a and thin 3b sections. The thick 3a and thin 3b sections together creates the metasurface, wherein the metasurface is leak suppressing in the way that it helps guide the wave and keep it within the waveguide channel 77 that the elongated aperture 7 is part of.

Figure 2 further illustrates a flat portion 4 surrounding the metasurface 3. The flat portion 4, in one embodiment has the same thickness as the thick sections 3a. In the embodiment as illustrated in figure 2 the thick sections 3a are arranged in straight rows 6a, 6b, 6c. In one embodiment the number of straight rows 6a, 6b, 6c could be one, two, three or more at any or all sides of the elongated aperture 7.

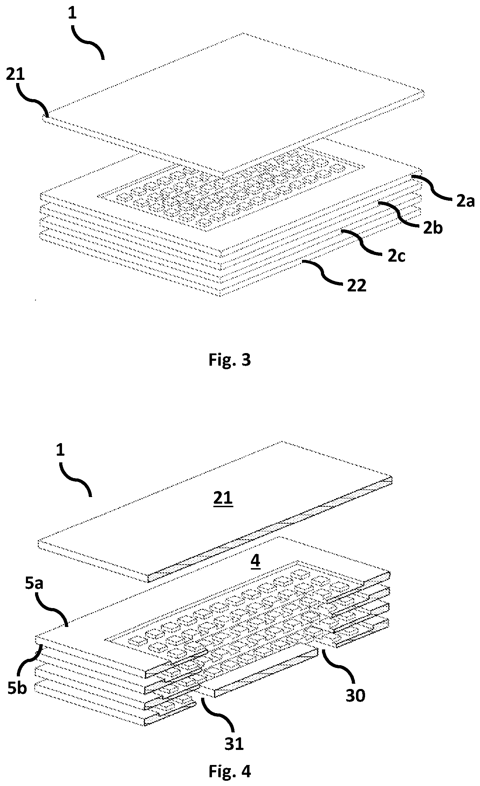

Figure 3 illustrates one embodiment of the multi-layer waveguide 1 wherein the layers are spaced apparat. This exploded view illustrates an important feature of the multi-layer waveguide 1 in that no galvanic, electric, or physical connection is required between the layers. I.e. a small gap can exist between the layers. This gap could for example be an uncontrolled air gap from production of the layers. The gap could also be on micron or even an atomic level. However, it shall be noted that the size of the gap as illustrated in figure 3 is only for illustration, the gap between the layers could typically be anywhere between 0 and 15 micrometers.

Figure 4 illustrates a cross-section of one embodiment of a multi-layer waveguide 1 wherein the entry 30 and exit 31 openings are visible. Those openings 30, 31 are the openings wherein the wave enter and exits the waveguide channel 77. Figure 4 further illustrates a first 5a and second 5b surface identified for one intermediate layer 2b. It shall be noted that each layer comprises a first 5a and second 5b surface. The entry 30 and exit 31 openings don't have to be arranged in the bottom layer 22. In another embodiment the entry 30 and exit 31 openings are instead arranged in the top layer 21. In yet another embodiment the entry 30 and exit 31 openings are arranged in different layers, for example, the entry opening 30 could be arranged in the top layer 21 and the exit opening 31 in the bottom layer 22, or vice versa.

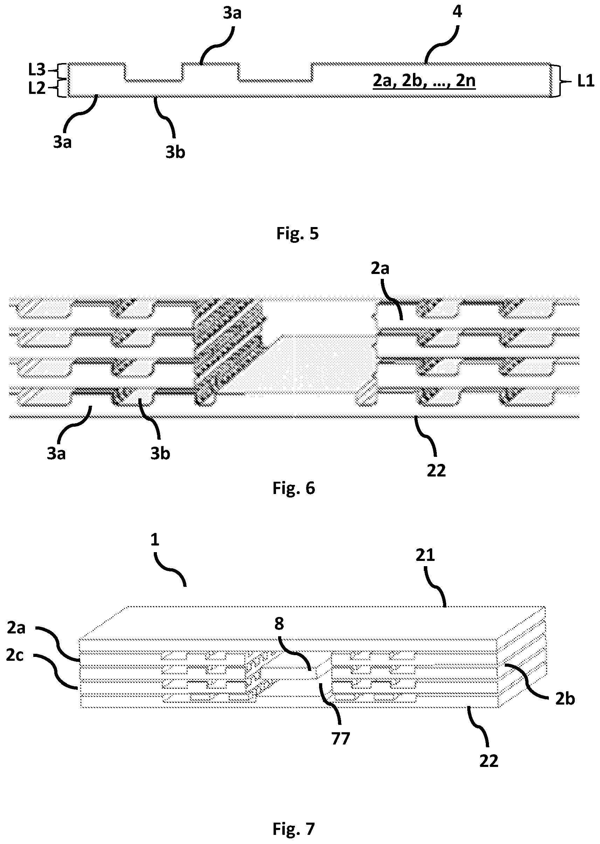

Figure 5 illustrates parts of an intermediate layer 2a, 2b, ..., 2n or part of a top 21 or bottom 22 layer with a metasurface 3. Figure 5 illustrates differences in thickness between the thick 3a and thin 3b sections as well as the flat portion 4. The difference can for example be between 50-70%, 50-60%, 55-65%, or 60-70% of the total thickness of the layer, however the difference in thickness might vary also outside said range.

Figure 6 illustrates one embodiment of the metasurfaces 3 wherein the metasurface 3 was produced by metal chemical etching creating a characteristic shape of the edges in the metasurface, the shape of the edges in the metasurface becomes rounded. It shall be noted that other production methods such as CNC, laser cutting etc. also are possible.

Figure 7 illustrates a co-axial multi-layer waveguide 1 wherein the waveguide channel 77 comprises a central member 8 arranged within the elongated aperture 7 of one intermediate layer 2a, 2b, 2c, ..., 2n. The center member 8 is attached to the rest of the layer at one or more place connecting the central member to the layer and keeping it in place.

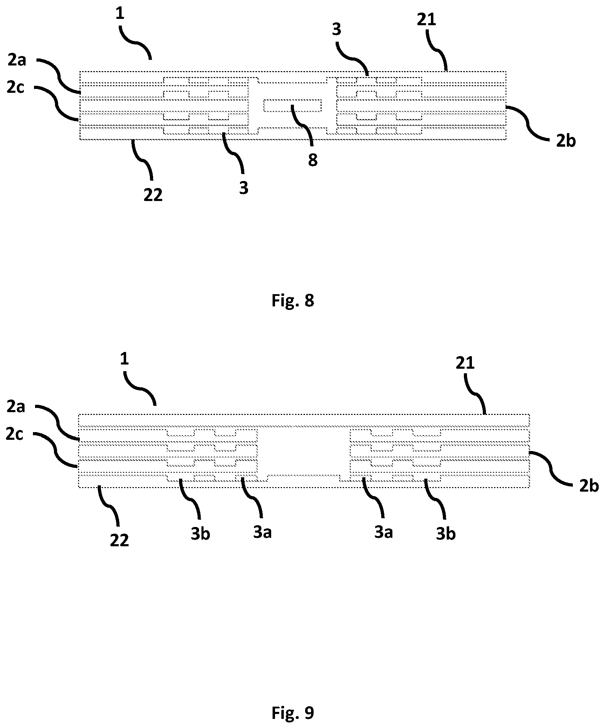

Figure 8 illustrates one embodiment of a co-axial multi-layer waveguide 1 wherein the top 21 and bottom 22 layers have metasurfaces 3. It shall be noted that the top 21 and bottom 22 layers in some embodiments have metasurfaces 3 and in some they don't. Further, in some embodiment, as illustrated in for example figure 8, one or more intermediate layer doesn't have a metasurface 3.

Figure 9 illustrates another embodiment of a multi-layer waveguide 1 wherein the top layer 21 don't have any metasurface but the intermediate layers 2a, 2b, 2c and the bottom layer 22 have metasurfaces.

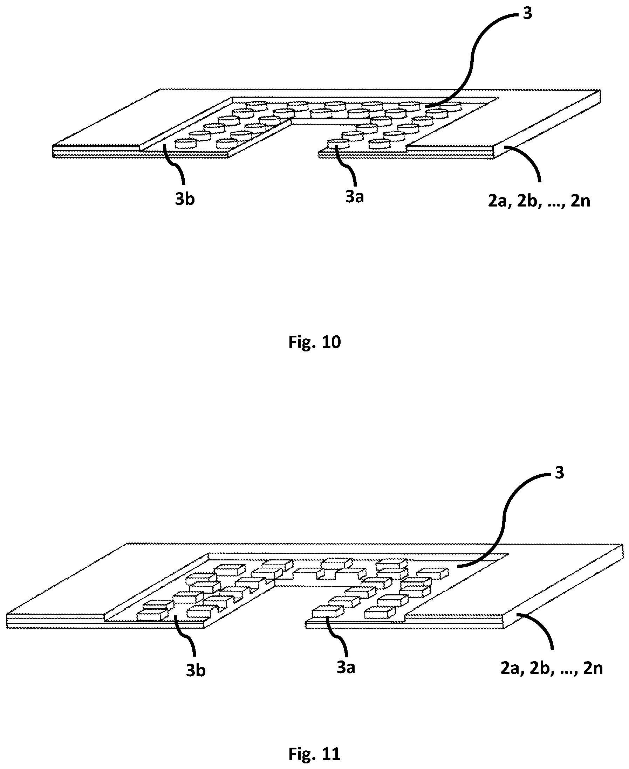

Figure 10 illustrates one embodiment of an intermediate layer 2a, 2b, 2c, ..., 2n, wherein the thick sections 3a have a round shape. It shall be noted that the shape is not important to the functionality and the metasurface 3 may have thick sections 3a of many different shapes, both in the same and in different metasurfaces 3.

Figure 11 illustrates another embodiment wherein the thick sections 3a of the metasurface 3 are randomly placed around the elongated aperture 7. Figure 11 is a representation of how the thick sections 3a could be arranged but it shall be noted that describes herein is only different possible embodiments and other arrangements of the thick sections 3a is also possible within the scope of the claims. The small gap between the layers and the metasurface provide the electromagnetic bandgap (EBG) structure.

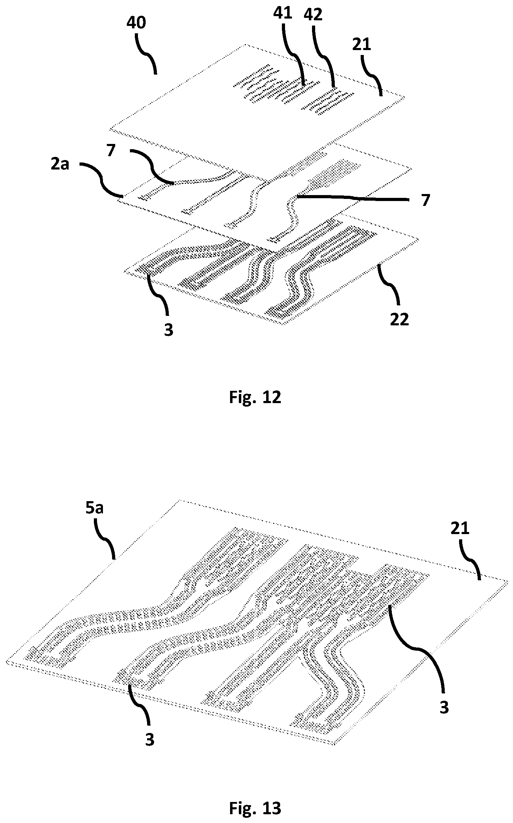

Figure 12 illustrates an exploded isometric view of a multi-layer slotted waveguide antenna 40 as one implementation of waveguides 1 as described herein. The embodiment as illustrated in figure 12 shows a top layer 21, an intermediate layer 2a, and a bottom layer 22. The top layer 21 comprise antenna slots 41 and corrugations 42 arranged at one end of the waveguide 1. The intermediate layer 2a comprise elongated apertures 7 providing routing in each waveguide 1. The bottom 22 and the top layer 21 comprise meta surfaces 3 arranged to surround the elongated apertures 7 of the intermediate layer 2a.

The elongated apertures 7 as illustrated in Figure 12 comprise support structures for enhancing the mechanical support of the layer. The support structures are arranged within the elongated apertures 7 providing an embodiment wherein multiple elongated apertures 7 are arranged instead of a single aperture extending the entire length. In one embodiment this is merely for structural support.

Figure 13 illustrates a bottom view of the top layer 21 as illustrated in Figure 12. As shown, the top layer 21 in one embodiment comprises meta surfaces 3 arranged to surround the elongated apertures 7 of the intermediate layer 2a. As understood, the embodiments as illustrated in figures 12 and 13 are merely examples of how the solution as described herein could be implemented as a slotted waveguide antenna 40. Figure 12 and 13 further illustrates how the routing of the waveguide 1 may differ depending of the implementation. For example, the routing may in one embodiment be straight and in another comprise one or more turns.

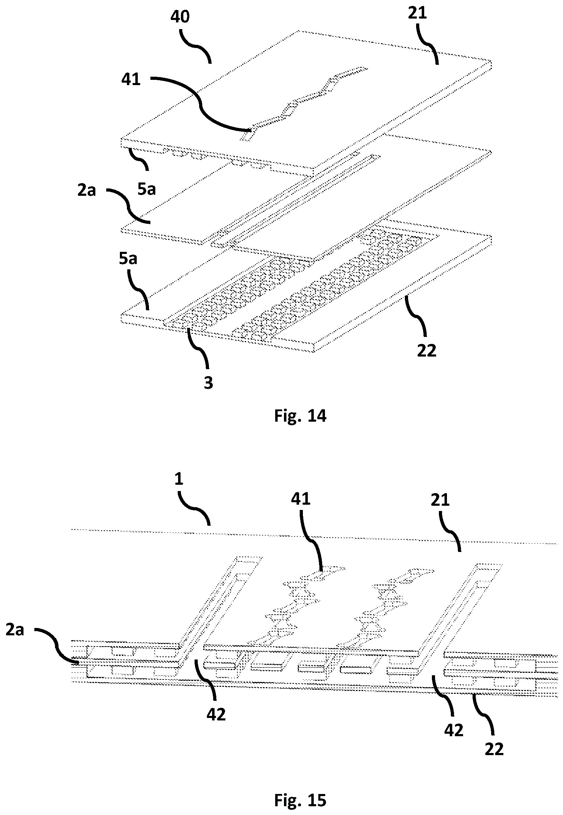

Figure 14 illustrate one embodiment of a multi-layer waveguide 1 implemented as a slotted waveguide antenna 40. Figure 15 illustrate a slightly more complex multi-layer waveguide 1 implemented as a slotted waveguide antenna 40 wherein corrugations 42 are arranged to reduce ripple in the transmission pattern. The corrugations 42 reduce surface currents in the top layer and thus enhance the propagation pattern. As illustrated in Figure 14 the corrugations 42 extend through the top 21 and intermediate layer 2a. In another embodiment wherein the multi-layer waveguide implemented as a slotted waveguide antenna 40 comprise additional intermediate layers 2b, 2c, ..., 2n, the corrugations 42 extends through the top layer 21 and the intermediate layers 2a, 2b, 2c, ..., 2n. In yet another embodiment the corrugations 42 extend through at least the top layer 21 and at least some of the intermediate layers 2a, 2b, 2c, ..., 2n.

## Claims

1. A multi-layer waveguide (1) comprising at least three physical layers (21, 2a, 22) assembled into said multi-layer waveguide (1), wherein the three physical layers are:
a top layer (21),
an intermediate layer (2a), and
a bottom layer (22),
wherein the intermediate layer (2a) comprises a waveguide channel (77) being an elongated aperture (7),
wherein at least one layer (21, 2a, 22) has a metasurface on a surface facing another layer,
wherein the metasurface (3) is arranged to surround the elongated aperture (7) of the intermediate layer (2a) and the metasurface (3) is a textured surface, having a sub-wavelength thickness below the wavelength divided by 10, created by thick (3a) and thin (3b) sections,
wherein the top layer (21) has a metasurface (3) on a surface facing a first side of the intermediate layer (2a) and the bottom layer (22) has a metasurface (3) on a surface facing a second side of the intermediate layer (2a), and
wherein the intermediate layer (2a) has/forms a flat surface on the first or second side except for the elongated aperture.

2. The multi-layer waveguide (1) according to any of the preceding claims, wherein the at least three physical layers are stacked unconnected thin metal layers or layers made of a single material coated with a metal.

3. The multi-layer waveguide (1) according any of the preceding claims, wherein the top (21), bottom (22) or intermediate (2a) layer has a surface with a flat portion (4) surrounding the metasurface (3), and wherein the thick sections (3a) have a thickness corresponding to the layer thickness (L1) at the flat portion (4) and the thin sections (3b) have a thickness (L2) that is less than the thickness at the flat portion (4).

4. The multi-layer waveguide (1) according to any of the preceding claims, wherein each thick section (3a) has any one of a circular, elliptical, triangular, pentagonal, rectangular, square or hexagonal shape.

5. The multi-layer waveguide (1) according to any of the preceding claims, wherein the thick sections (3a) are arranged in rows (6a, 6b, 6c, ..., 6n) parallel to the elongated aperture (7) or arranged at irregular distances from the elongated aperture (7).

6. The multi-layer waveguide (1) according to any one of the preceding claims, wherein the difference in thickness (L3) between the thick sections (3a) and the thin sections (3b) of the metasurface (3) is between 50-70% of the total thickness of the respective layer, or the difference in thickness (L3) between the thick sections (3a) and the thin sections (3b) of the metasurface (3) is less than the wavelength divided by 20, or less than the wavelength divided by 25.

7. A multi-layer waveguide antenna (40), comprising the multi-layer waveguide (1) according to any of the preceding claims, wherein the top layer (21) is provided with antenna slots (41).

8. A multi-layer waveguide (1) comprising five physical layers (21, 2a, 2b, 2c, 22) assembled into said multi-layer waveguide (1), wherein the five physical layers comprises:
a top layer (21),
a first, second and third intermediate layer (2a, 2b, 2c), the second intermediate layer (2b) being arranged between the first intermediate layer (2a) and the third intermediate layer (2c), and
a bottom layer (22),
wherein each intermediate layer (2a, 2b, 2c) comprises an elongated aperture (7),
wherein the apertures (7) of the intermediate layers (2a, 2b, 2c) forms a waveguide channel (77),
wherein a central member (8) is arranged within the elongated aperture (7) of the second intermediate layer (2b),
wherein at least one of said five physical layers (21, 2a, 2b, 2c, 22) has a metasurface on a surface facing a flat surface of another of said five physical layers, and
wherein the metasurface (3) is arranged to surround the elongated apertures (7) of the three intermediate layers (2a, 2b, 2c) and comprises thick (3a) and thin (3b) sections.

9. A method for producing a multi-layer waveguide (1) according to any of the preceding claims.

## Patentansprüche

1. Mehrschichtiger Hohlleiter (1), aufweisend mindestens drei physische Schichten (21, 2a, 22), die zu dem mehrschichtigen Hohlleiter (1) zusammengesetzt sind, wobei die drei physischen Schichten sind:
eine obere Schicht (21),
eine Zwischenschicht (2a), und
eine untere Schicht (22),
wobei die Zwischenschicht (2a) einen Hohlleiterkanal (77) aufweist, der eine längliche Öffnung (7) ist,
wobei mindestens eine Schicht (21, 2a, 22) auf einer einer anderen Schicht gegenüberliegenden Fläche eine Metafläche aufweist,
wobei die Metafläche (3) so angeordnet ist, dass sie die längliche Öffnung (7) der Zwischenschicht (2a) umschließt, und die Metafläche (3) eine texturierte Fläche ist, die eine Unter-Wellenlängendicke unterhalb der durch 10 geteilten Wellenlänge aufweist und durch dicke Abschnitte (3a) und dünne Abschnitte (3b) erzeugt wird,
wobei die obere Schicht (21) eine Metafläche (3) auf einer Fläche aufweist, die einer ersten Seite der Zwischenschicht (2a) zugewandt ist, und die untere Schicht (22) eine Metafläche (3) auf einer Fläche aufweist, die einer zweiten Seite der Zwischenschicht (2a) gegenüberliegt, und
wobei die Zwischenschicht (2a) auf der ersten oder zweiten Seite mit Ausnahme der länglichen Öffnung eine ebene Fläche aufweist/bildet.

2. Mehrschichtiger Hohlleiter (1) nach einem der vorhergehenden Ansprüche, wobei die mindestens drei physischen Schichten gestapelte, unverbundene dünne Metallschichten oder Schichten aus einem einzigen, mit einem Metall beschichteten Material sind.

3. Mehrschichtiger Hohlleiter (1) nach einem der vorhergehenden Ansprüche, wobei die obere Schicht (21), die untere Schicht (22) oder die Zwischenschicht (2a) eine Fläche mit einem flachen Abschnitt (4) aufweist, der die Metafläche (3) umschließt, und wobei die dicken Abschnitte (3a) eine Dicke aufweisen, die der Schichtdicke (L1) an dem flachen Abschnitt (4) entspricht, und die dünnen Abschnitte (3b) eine Dicke (L2) aufweisen, die geringer ist als die Dicke an dem flachen Abschnitt (4).

4. Mehrschichtiger Hohlleiter (1) nach einem der vorhergehenden Ansprüche, wobei jeder dicke Abschnitt (3a) eine kreisförmige, elliptische, dreieckige, fünfeckige, rechteckige, quadratische oder sechseckige Form aufweist.

5. Mehrschichtiger Hohlleiter (1) nach einem der vorhergehenden Ansprüche, wobei die dicken Abschnitte (3a) in Reihen (6a, 6b, 6c, ..., 6n) parallel zu der länglichen Öffnung (7) oder in unregelmäßigen Entfernungen zu der länglichen Öffnung (7) angeordnet sind.

6. Mehrschichtiger Hohlleiter (1) nach einem der vorhergehenden Ansprüche, wobei der Dickenunterschied (L3) zwischen den dicken Abschnitten (3a) und den dünnen Abschnitten (3b) der Metafläche (3) zwischen 50 - 70 % der Gesamtdicke der jeweiligen Schicht beträgt, oder der Dickenunterschied (L3) zwischen den dicken Abschnitten (3a) und den dünnen Abschnitten (3b) der Metafläche (3) kleiner als die Wellenlänge geteilt durch 20 oder kleiner als die Wellenlänge geteilt durch 25 ist.

7. Mehrschichtige Hohlleiterantenne (40), aufweisend den mehrschichtigen Hohlleiter (1) nach einem der vorhergehenden Ansprüche, wobei die obere Schicht (21) mit Antennenschlitzen (41) versehen ist.

8. Mehrschichtiger Hohlleiter (1) aufweisend fünf physische Schichten (21, 2a, 2b, 2c, 22), die zu dem mehrschichtigen Hohlleiter (1) zusammengesetzt sind, wobei die fünf physischen Schichten aufweisen:
eine obere Schicht (21),
eine erste, eine zweite und eine dritte Zwischenschicht (2a, 2b, 2c), wobei die zweite Zwischenschicht (2b) zwischen der ersten Zwischenschicht (2a) und der dritten Zwischenschicht (2c) angeordnet ist, und
eine untere Schicht (22),
wobei jede Zwischenschicht (2a, 2b, 2c) eine längliche Öffnung (7) aufweist, wobei die Öffnungen (7) der Zwischenschichten (2a, 2b, 2c) einen Hohlleiterkanal (77) bilden,
wobei ein zentrales Element (8) innerhalb der länglichen Öffnung (7) der zweiten Zwischenschicht (2b) angeordnet ist,
wobei mindestens eine der fünf physischen Schichten (21, 2a, 2b, 2c, 22) eine Metafläche auf einer Fläche aufweist, die einer flachen Fläche einer anderen der fünf physischen Schichten gegenüberliegt, und
wobei die Metafläche (3) so angeordnet ist, dass sie die länglichen Öffnungen (7) der drei Zwischenschichten (2a, 2b, 2c) umschließt und dicke Abschnitte (3a) und dünne Abschnitte (3b) aufweist.

9. Verfahren zum Herstellen eines mehrschichtigen Hohlleiters (1) nach einem der vorhergehenden Ansprüche.

## Revendications

1. Guide d'ondes multicouches (1) comprenant au moins trois couches métalliques physiques (21, 2a, 22) assemblées dans ledit guide d'ondes multicouches (1), dans lequel les trois couches physiques sont
une couche supérieure (21),
une couche intermédiaire (2a) et
une couche inférieure (22),
dans lequel la couche intermédiaire (2a) comprend **un** canal de guide d'ondes (77) étant une ouverture allongée (7),
dans lequel au moins une couche (21, 2a, 22) présente une métasurface (3) sur une surface faisant face à une autre couche,
dans lequel la métasurface (3) est agencée pour entourer l'ouverture allongée (7) de la couche intermédiaire (2a) et la métasurface (3) est une surface texturée, présentant une épaisseur de sous-longueur d'onde inférieure à la longueur d'onde divisée par 10, créé par des sections épaisses (3a) et minces (3b),
dans lequel la couche supérieure (21) présente une métasurface (3) sur une surface faisant face à **un** premier côté de la couche intermédiaire (2a) et la couche inférieure (22) présente une métasurface (3) sur une surface faisant face à **un** deuxième côté de la couche intermédiaire (2a) et
dans lequel la couche intermédiaire (3a) présente/ forme une surface plate sur le premier ou deuxième côté à l'exception de l'ouverture allongée.

2. Guide d'ondes multicouches (1) selon une quelconque des revendications précédentes, dans lequel les au moins trois couches physiques sont des couches métalliques minces empilées non connectées ou des couches constituées d'un matériau unique revêtu d'un métal.

3. Guide d'ondes multicouches (1) selon une quelconque des revendications précédentes, dans lequel la couche supérieure (21), inférieure (22) ou intermédiaire (2a) présente une surface avec une partie plate (4) entourant la métasurface (3) et dans lequel les sections épaisses (3a) ont une épaisseur correspondant à l'épaisseur de couche (L1) au niveau de la partie plate (4) et les sections minces (3b) ont une épaisseur (L2) qui est inférieure à l'épaisseur au niveau de la partie plate (4) .

4. Guide d'ondes multicouches (1) selon une quelconque des revendications précédentes, dans lequel chaque section épaisse (3a) a une quelconque des formes circulaire, elliptique, triangulaire, carrée, pentagonale, rectangulaire, rectangulaire, carrée, hexagonale ou rectangulaire.

5. Guide d'ondes multicouches selon une quelconque des revendications précédentes, dans lequel les sections épaisses (3a) sont disposées en rangées (6a, 6b, 6c, ..., 6n) parallèles à l'ouverture allongée (7) ou disposées à distances irrégulières de l'ouverture allongée (7).

6. Guide d'ondes multicouches (1) selon une quelconque des revendications précédentes, dans lequel la différence d'épaisseur (L3) entre les sections épaisses (3a) et les sections minces (3b) de la métasurface (3) est comprise entre 50-70 % de l'épaisseur totale de la couche respective ou la différence d'épaisseur (L3) entre les sections épaisses (3a) et les sections minces (3b) de la métasurface est inférieure à la longueur d'onde divisée par 20 ou inférieure à la longueur d'onde divisée par 25.

7. Antenne à guide d'ondes multicouches (40) comprenant le guide d'ondes multicouches (1) selon une quelconque des revendications précédentes, dans lequel la couche supérieure (21) est munie de fentes d'antenne (41).

8. Guide d'ondes multicouches (1) comprenant cinq couches physiques (21,2a, 2b, 2c, 22) assemblé en ledit guide d'ondes multicouches (1), dans lequel les cinq couches physiques comprennent
une couche supérieure (21),
une première, deuxième et troisième couche intermédiaire (2a, 2b, 2c), la deuxième couche intermédiaire (2b) étant disposée entre la première couche intermédiaire (2a) et la troisième couche intermédiaire (2c) et
une couche inférieure (22),
dans lequel chaque couche intermédiaire (2a, 2b, 2c) comprend une ouverture allongée (7),
dans lequel les ouvertures (7) des couches intermédiaires (2a, 2b, 2c) forment un canal de guide d'ondes (77),
dans lequel un élément central (8) est disposé à l'intérieur de l'ouverture allongée (7) de la deuxième couche intermédiaire (2b),
dans lequel au moins une desdites cinq couches physiques (21, 2a, 2b, 2c, 22) présente une métasurface sur une surface faisant face à une autre desdites cinq couches physiques et
dans lequel la métasurface (3) est agencée afin d'entourer les ouvertures allongées (7) des trois couches intermédiaires (2a, 2b, 2c) et comprend des sections épaisses (3a) et minces (3b).

9. Procédé de production d'un guide d'ondes multicouches (1) selon une quelconque des revendications précédentes.
